(19) Europäisches Patentamt
European Patent Office
Office européen des brevets

(11) **EP 2 495 613 B1**

(12) **EUROPEAN PATENT SPECIFICATION**

(45) Date of publication and mention
of the grant of the patent:
**31.07.2013 Bulletin 2013/31**

(51) Int Cl.:
***G03F 7/20*** (2006.01)

(21) Application number: **12169023.4**

(22) Date of filing: **10.11.2003**

(54) **Lithographic apparatus**

Lithografische Vorrichtung

Appareil lithographique

(84) Designated Contracting States:
**DE FR GB IT NL**

(30) Priority: **12.11.2002 EP 02257822**
**13.05.2003 EP 03252955**

(43) Date of publication of application:
**05.09.2012 Bulletin 2012/36**

(62) Document number(s) of the earlier application(s) in
accordance with Art. 76 EPC:
**03257070.7 / 1 420 298**

(73) Proprietor: **ASML Netherlands B.V.**
**5504 DR Veldhoven (NL)**

(72) Inventors:
• **Lof, Joeri**
**5616 BW Eindhoven (NL)**
• **De Smit, Joannes Theodoor**
**5581 AJ Waalre (NL)**
• **Straaijer, Alexander**
**5644 KK Eindhoven (NL)**
• **Streefkerk, Bob**
**5038 PE Tilburg (NL)**
• **Van Santen, Helmar**
**1019 PW Amsterdam (NL)**
• **Derksen, Antonius**
**6661 BR Elst (NL)**
• **Hoogendam, Christiaan**
**5563 AR Westerhoven (NL)**
• **Kolesnychenko, Aleksey**
**5701 EE Helmond (NL)**
• **Loopstra, Erik**
**5613 ES Eindhoven (NL)**
• **Modderman, Theodorus**
**5672 HW Nuenen (NL)**
• **Mulkens, Johannes**
**5552 MA Valkenswaard (NL)**
• **Ritsema, Roelof**
**5615 RK Eindhoven (NL)**
• **Simon, Klaus**
**5655 CP Eindhoven (NL)**

(74) Representative: **Maas, Abraham Johannes et al**
**ASML Netherlands B.V.**
**Corporate Intellectual Property**
**P.O. Box 324**
**5500 AH Veldhoven (NL)**

(56) References cited:
**DD-A1- 224 448 US-A- 3 648 587**
**US-A- 4 509 852**

• **PATENT ABSTRACTS OF JAPAN vol. 1999, no. 2, 26 February 1999 (1999-02-26) -& JP 10, 303114, A, (NIKON CORP), 13 November 1998 (1998-11-13)**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

The present invention relates to a lithographic projection apparatus comprising:

- a radiation system for supplying a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- a liquid supply system for at least partly filling a space between the final element of said projection system and said substrate with a liquid, said space being in

liquid connection with a liquid reservoir through a duct.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required.
- A programmable LCD array. An example of such a construction is given in United States Patent US 5,229,872. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (e.g. silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus -commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

It has been proposed to immerse the substrate in a lithographic projection apparatus in a liquid having a relatively high refractive index, e.g. water, so as to fill a space between the final element of the projection system and the substrate. The point of this is to enable imaging of smaller features since the exposure radiation will have a shorter wavelength in the liquid. (The effect of the liquid may also be regarded as increasing the effective NA of the system.)

However, submersing the substrate table in liquid means that there is a large body of liquid that must be accelerated during a scanning exposure. This requires additional or more powerful motors and turbulence in the liquid may lead to undesirable and unpredictable effects.

There are several difficulties associated with having liquids in a lithographic projection apparatus. For example, escaping liquid can cause a problem by interfering with interferometers and, if the lithographic projection apparatus requires the beam to be held in a vacuum, by destroying the vacuum. Furthermore, the liquid can be used up at a high rate unless suitable precautions are taken.

Further problems associated with immersion lithography include the difficulty in keeping the depth of the liquid constant and transfer of substrates to and from the imaging position i.e. under the final projection system element. Also, contamination of the liquid (by chemicals dissolving in it) and increase in temperature of the liquid deleteriously affect the imaging quality achievable.

In the event of a computer failure or power failure or loss of control of the apparatus for any reason, steps need to be taken to protect, in particular, the optical elements of the projection system. It may be necessary to take steps to avoid spillage of the liquid over other components of the apparatus.

If a liquid supply system is used in which the liquid has a free surface, steps need to be taken to avoid the development of waves in that free surface due to forces applied to the liquid supply system. Waves can transfer vibrations to the projection system from the moving substrate.

WO 99/49504 discloses a lithographic apparatus in which a liquid is supplied to the space between the projection lens and the wafer. As the wafer is scanned beneath the lens in a -X direction, liquid is supplied at the +X side of the lens and taken up at the -X side. German patent application DD 224 448 A1 discloses a lithographic projection apparatus. The projection lens produces an exposure pattern on a photosensitive layer applied to a semiconductor substrate. An immersion fluid with a refractive index of about the same as that of the photo-sensitive layer is contained in the light path between the lens and the photosensitive layer. The immersion fluid is contained within two abutting sealed chambers respectively bounded by the lens and the substrate and divided from one another via a transparent surface.

It is an object of the present invention to provide a lithographic projection apparatus in which a space between the substrate and the projection system is filled with a liquid whilst minimizing the transmission of disturbance forces between the substrate and projection system.

This and other objects are achieved according to the invention in a lithographic apparatus as specified in the opening paragraph, characterized in that the cross sectional area of said duct in a plane perpendicular to the direction of fluid flow is at least $\pi \left( \dfrac{8 \Delta V \eta L}{\pi \Delta P_{max} t_{min}} \right)^{1/2}$ ,

where $\Delta V$ is the volume of liquid which has to be removed from said space within time $t_{min}$, $L$ is the length of the duct, $\eta$ is viscosity of liquid in said space and $\Delta P_{max}$ is the maximum allowable pressure on said final element.

This apparatus has the advantage that the liquid can be completely constrained such that it does not have a large free surface for the development of waves i.e. the space or reservoir is enclosed at the top and the reservoir is full of liquid. This is because the amount of fluid which can flow through the duct in a given time (time of crash measured experimentally) is large enough to avoid damage to the final element of the projection system when the apparatus crashes because the liquid can escape through the duct before pressure in the space build up to levels at which damage can occur. The liquid must escape when the seal member moves relative to the final element otherwise the hydrostatic pressure applied to the final element during relative movement of the final element to the seal member can damage the final element.

Preferably, the liquid supply system comprises:

- a seal member extending along at least a part of the boundary of said space between the final element of said projection system and said substrate table; and
- a gas seal means for forming a gas seal between said seal member and the surface of said substrate, and wherein

the gas seal means comprises a gas inlet and a first gas outlet formed in a face of said seal member that opposes said substrate, means for supplying gas und pressure to said gas inlet and vacuum means for extracting gas from said first gas outlet. The gas seal means thus forms a non-contact seal between the seal member and the substrate so that the liquid is contained in the space between the final element of the projection system and the substrate, even as the substrate moves under the projection system, e.g. during a scanning exposure. The seal member may be provided in the form of a closed loop, whether circular, rectangular, or other shape, around the space or may be incomplete, *e.g.* forming a U-shape or even just extending along one side of the space. If the seal member is incomplete, it should be positioned to confine the liquid as the substrate is scanned under the projection system. Preferably, the gas seal means is a gas bearing for supporting said seal member. This has the advantage that the same part of the liquid supply system can be used both for bearing and for sealing the liquid in a space between the final element of the projection system and the substrate, thereby reducing the complexity and weight of the seal member. Also, previous experience gained in the use of gas bearings in vacuum environments can be called on. More preferably, the gas inlet is located further outward from the optical axis of said projection system than said first gas outlet. In this way, the gas flow in the gas seal is inward and most efficiently contains the liquid. In this case, the gas seal means advantageously further comprises a second gas outlet formed in the face of the seal member which opposes the substrate, the first and second gas outlets being formed on opposite sides of the gas inlet. The second gas outlet ensures minimal escape of gas from the gas inlet into the environment surrounding the seal member. Thus, the risk of gas escaping and interfering with the interferometers or degrading a vacuum in the lithographic apparatus, is minimized.

The liquid supply system may also comprise sensors for measuring the distance between the face of the seal member and the substrate and/or the topography of the top surface of the substrate. In this way, control means can be used to vary the distance between the face of the seal member and the substrate by controlling, for example, the gas seal means either in a feed-forward or a feed-back manner.

The apparatus may further comprise means for varying the level of a portion of said face of said seal member between the first gas outlet and an edge of the face nearest the optical axis relative to the remainder of the face. This allows the pressure containing the liquid in the space, to be controlled independently of the pressure below the inlet so that the height of the seal member over the substrate can be adjusted without upsetting the balance of forces holding the liquid in the space. An alternative way of ensuring this is to use a means for varying the level of a portion of the face between the first or second gas outlets and the gas inlet relative to the remainder of the face. Those three systems may be used in any combination.

An alternative way of separating a sealing function and bearing function of the gas seal means is to provide a channel formed in the face of the seal member located nearer to the optical axis of the projection system than the first gas outlet. The pressure in that channel can be varied to contain the liquid in the space whereas the gas in and out-lets may be used to vary the height of the seal member above the substrate so that they only operate to support the seal member and have little, if any, sealing function.

A further advantageous feature is for a porous member to be disposed over the gas inlet for evenly distributing gas flow over the area of the gas inlet.

It is convenient to form the gas in and out-lets so that each comprises a groove in said face of said seal member opposing said substrate and a plurality of conduits leading into said groove at spaced locations.

It is also preferred that the gap between said seal member and the surface of said substrate inwardly of said gas seal means is small so that capillary action draws liquid into the gap and/or gas from the gas seal means is prevented from entering the space. The balance between the capillary forces drawing liquid under the seal member and the gas flow pushing it out forms a particularly stable seal.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm).

Embodiments of the invention will now be described, by way of example only, with reference to the accompanying schematic drawings, in which:

Figure 1 depicts a lithographic projection apparatus according to an embodiment;
Figure 2 depicts the liquid reservoir of the first embodiment;
Figure 3 is an enlarged view of part of the liquid reservoir of the first embodiment;
Figure 4 depicts the liquid reservoir of the second embodiment;
Figure 5 is an enlarged view of part of the liquid reservoir of the second embodiment;
Figure 6 is an enlarged view of the liquid reservoir of the third embodiment;
Figure 7 depicts the liquid reservoir of the fourth embodiment;
Figure 8 is an enlarged view of part of the reservoir of the fourth embodiment;
Figure 9 depicts the liquid reservoir of a fifth embodiment;
Figure 10 depicts the liquid reservoir of a sixth embodiment;
Figure 11 depicts, in plan, the underside of the seal member of the sixth embodiment;
Figure 12 depicts, in plan, the underside of the seal member of the seventh embodiment;
Figure 13 depicts, in cross section, the liquid reservoir of the seventh embodiment;
Figure 14 depicts, in cross section, the liquid reservoir of an eighth embodiment;
Figure 15 depicts, in cross section, the liquid reservoir of a ninth embodiment;
Figure 16 depicts, in cross section, the liquid reservoir of an alternative ninth embodiment; and
Figure 17 depicts, in cross section, the liquid reservoir of a tenth embodiment.

In the Figures, corresponding reference symbols indicate corresponding parts.

Embodiment 1

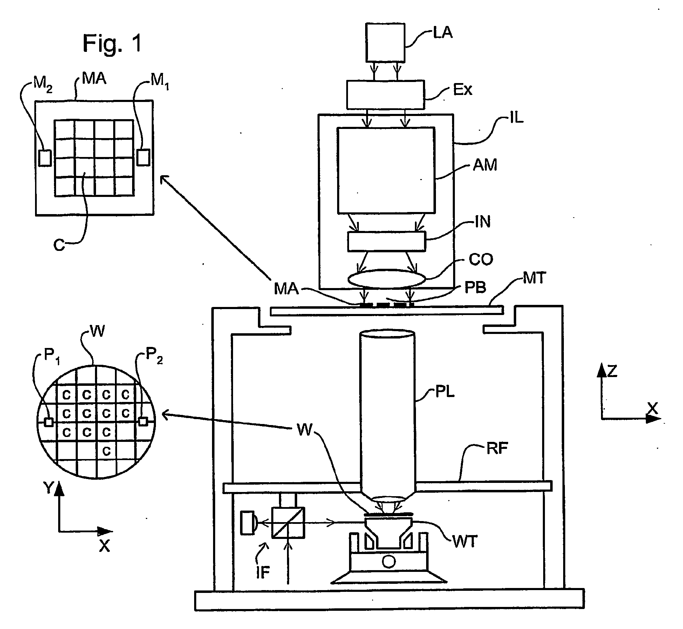

Figure 1 schematically depicts a lithographic projection apparatus according to a particular embodiment of the invention. The apparatus comprises:

· a radiation system Ex, IL, for supplying a projection beam PB of radiation (*e.g.* DUV radiation), which in this particular case also comprises a radiation source LA;
· a first object table (mask table) MT provided with a mask holder for holding a mask MA (*e.g.* a reticle), and connected to first positioning means for accurately positioning the mask with respect to item PL;
· a second object table (substrate table) WT provided with a substrate holder for holding a substrate W (*e.g.* a resist-coated silicon wafer), and connected to second positioning means for accurately positioning the substrate with respect to item PL;
· a projection system ("lens") PL (*e.g.* a refractive lens system) for imaging an irradiated portion of the mask MA onto a target portion C (*e.g.* comprising one or more dies) of the substrate W.

As here depicted, the apparatus is of a transmissive type (*e.g.* has a transmissive mask). However, in general, it may also be of a reflective type, for example (*e.g.* with a reflective mask). Alternatively, the apparatus may employ another kind of patterning means, such as a programmable mirror array of a type as referred to above.

The source LA (*e.g.* an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

- In step mode, the mask table MT is kept essentially stationary, and an entire mask image is projected in one go (*i.e,* a single "flash") onto a target portion C. The substrate table WT is then shifted in the x and/or y directions so that a different target portion C can be irradiated by the beam PB;
- In scan mode, essentially the same scenario applies, except that a given target portion C is not exposed in a single "flash". Instead, the mask table MT is movable in a given direction (the so-called "scan direction", *e.g.* the y direction) with a speed v, so that the projection beam PB is caused to scan over a mask image; concurrently,
- the substrate table WT is simultaneously moved in the same or opposite direction at a speed $V = Mv,$ in which $M$ is the magnification of the lens PL (typically, $M$ = 1/4 or 1/5). In this manner, a relatively large target portion C can be exposed, without having to compromise on resolution.

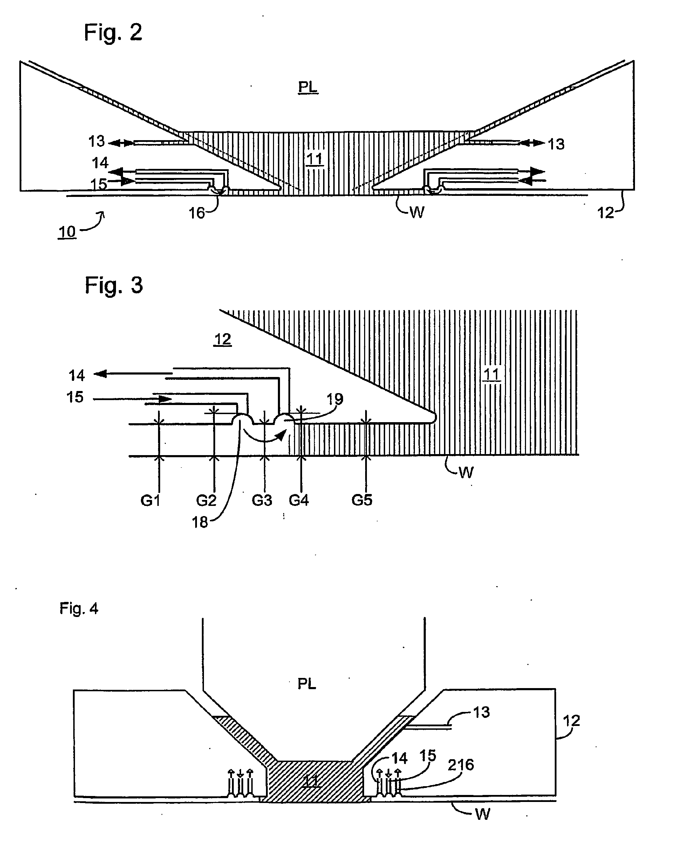

Figure 2 shows the liquid reservoir 10 between the projection system and the substrate stage. The liquid reservoir 10 is filled with a liquid 11 having a relatively high refractive index, e.g. water, provided via inlet/outlet ducts 13. The liquid has the effect that the radiation of the projection beam has a shorter wavelength in the liquid than in air or a vacuum, allowing smaller features to be resolved. It is well known that the resolution limit of a projection system is determined, *inter alia*, by the wavelength of the projection beam and the numerical aperture of the system. The presence of the liquid may also be regarded as increasing the effective numerical aperture. Furthermore, at fixed numerical aperture, the liquid is effective to increase the depth of field.

The reservoir 10 forms a contactless seal to the substrate around the image field of the projection system so that liquid is confined to fill a space between the substrate surface and the final element of the projection system. The reservoir is formed by a seal member 12 positioned below and surrounding the final element of the projection system PL. Liquid is brought into the space below the projection system and within the seal member 12. The seal member 12 extends a little above the final element of the projection system and the liquid level rises above the final element so that a buffer of liquid is provided. The seal member 12 has an inner periphery that at the upper end preferably closely conforms to the step of the projection system or the final element thereof and may, e.g., be round. At the bottom, the inner periphery closely conforms to the shape of the image field, e.g., rectangular though this need not be the case.

The liquid is confined in the reservoir by a gas seal 16 between the bottom of the seal member 12 and the surface of the substrate W. The gas seal is formed by gas, e.g. air or synthetic air but preferably $N_2$ or another inert gas, provided under pressure via inlet 15 to the gap between seal member 12 and substrate and extracted via first outlet 14. The overpressure on the gas inlet 15, vacuum level on the first outlet 14 and geometry of the gap are arranged so that there is a high-velocity air flow inwards that confines the liquid. This is shown in more detail in Figure 3.

The gas seal is formed by two annular grooves 18, 19 which are connected to the first inlet 15 and first outlet 14 respectively by a series of small conducts spaced around the grooves. The in-and out-lets 14, 15 may either be a plurality of discrete orifices around the circumference of the seal member 24 or may be continuous grooves or slits. A large annular hollow in the seal member may be provided in each of the inlet and outlet to form a manifold. The gas seal may also be effective to support the seal member 12 by behaving as a gas bearing.

Gap G1, on the outer side of the gas inlet 15, is preferably small and long so as to provide resistance to air flow outwards but need not be. Gap G2, at the radius of the inlet 15, is a little larger to ensure a sufficient distribution of gas around the seal member, the inlet 15 being formed by a number of small holes around the seal member. Gap G3 is chosen to control the gas flow through the seal. Gap G4 is larger to provide a good distribution of vacuum, the outlet 14 being formed of a number of small holes in the same manner as the inlet 15. Gap G5 is small to prevent gas/oxygen diffusion into the liquid in the space, to prevent a large volume of liquid entering and disturbing the vacuum and to ensure that capillary action will always fill it with liquid.

The gas seal is thus a balance between the capillary forces pulling liquid into the gap and the airflow pushing liquid out. As the gap widens from G5 to G4, the capillary forces decrease and the airflow increases so that the liquid boundary will lie in this region and be stable even as the substrate moves under the projection system PL.

The pressure difference between the inlet, at G2 and the outlet at G4 as well as the size and geometry of gap G3, determine the gas flow through the seal 16 and will be determined according to the specific embodiment. However, a possible advantage is achieved if the length of gap G3 is short and absolute pressure at G2 is twice that at G4, in which case the gas velocity will be the speed of sound in the gas and cannot rise any higher. A stable gas flow will therefore be achieved.

The gas outlet system can also be used to completely remove the liquid from the system by reducing the gas inlet pressure and allowing the liquid to enter gap G4 and be sucked out by the vacuum system, which can easily be arranged to handle the liquid, as well as the gas used to form the seal. Control of the pressure in the gas seal can also be used to ensure a flow of liquid through gap G5 so that liquid in this gap that is heated by friction as the substrate moves does not disturb the temperature of the liquid in the space below the projection system.

The shape of the seal member around the gas inlet and outlet should be chosen to provide laminar flow as far as possible so as to reduce turbulence and vibration. Also, the gas flow should be arranged so that the change in flow direction at the liquid interface is as large as possible to provide maximum force confining the liquid.

The liquid supply system circulates liquid in the reservoir 10 so that fresh liquid is provided to the reservoir 10.

The gas seal 16 can produce a force large enough to support the seal member 12. Indeed, it may be necessary to bias the seal member 12 towards the substrate to make the effective weight supported by the seal member 12 higher. The seal member 12 will in any case be held in the XY plane (perpendicular to the optical axis) in a substantially stationary position relative to and under the projection system but decoupled from the projection system. The seal member 12 is free to move in the Z direction and Rx and Ry.

Embodiment 2

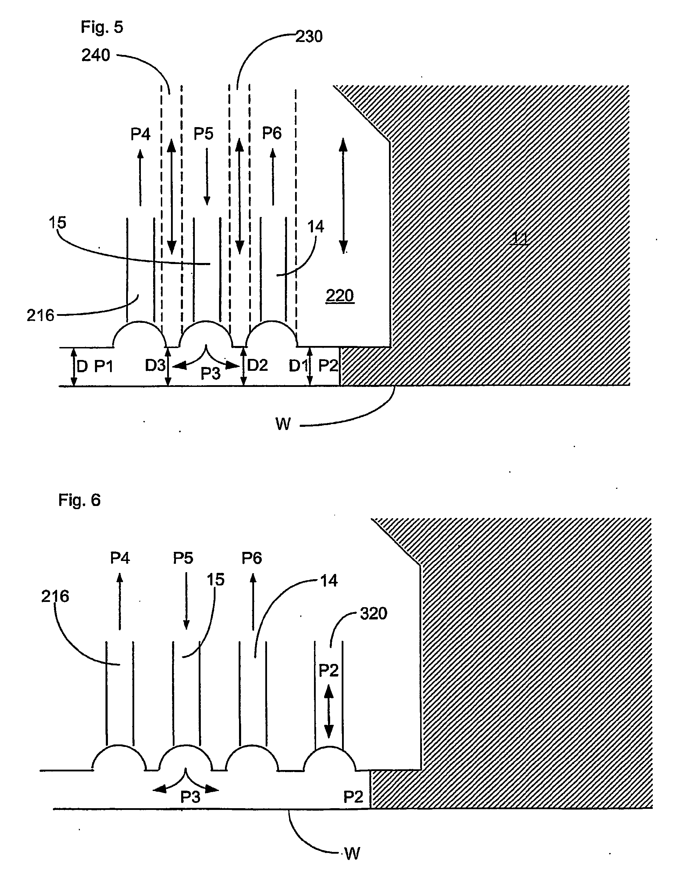

The second embodiment is illustrated in Figures 4 and 5 and is the same as the first embodiment except as described below.

In this embodiment a second gas outlet 216 is provided on the opposite side of the gas inlet 15 to the first gas outlet 14. In this way any gas escaping from the gas inlet 15 outwards away from the optical axis of the apparatus is sucked up by second gas outlet 216 which is connected to a vacuum source. In this way gas is prevented from escaping from the gas seal so that it cannot interfere, for example, with interferometer readings or with a vacuum in which the projection system and/or substrate are housed.

Another advantage of using the two gas outlet embodiment is that the design is very similar to that of air bearings previously used in lithographic projection apparatus. Thus the experience gained with those air bearings can be applied directly to the gas seal of this embodiment. The gas seal of the second embodiment is particularly suitable for use as gas bearing, as well as a seal means, such that it can be used to support the weight of the seal member 12.

Advantageously sensors may be provided to either measure the distance between the bottom face of the seal member 12 and the substrate W or the topography of the top surface of the substrate W. A control means may then be used to vary the pressures applied to the gas in- and out-lets 14, 15, 216 to vary the pressure P2 which constrains the liquid 11 in the reservoir and the pressures P1 and P3 which support the seal member 12. Thus the distance D between the seal member 12 and the substrate W may be varied or kept at a constant distance. The same control means may be used to keep the seal member 12 level. The control means may be controlled either by a feed forward or a feedback control loop.

Figure 5 shows in detail how the gas seal can be regulated to control independently the pressure P2 holding the liquid 11 in the reservoir and P3 which supports the seal member 12. This extra control is advantageous because it provides a way of minimizing liquid losses during operation. The second embodiment allows pressures P2 and P3 to be controlled independently to account for varying conditions during exposure. Varying conditions might be different levels of liquid loss per unit time because of different scanning speeds or perhaps because the edge of a substrate W is being overlapped by the seal member 12. This is achieved by providing means for varying the distance to the substrate W of discrete portions of the face of the seal member 12 facing the substrate W. These portions include the portion 220 between the first gas outlet 14 and the edge of the seal member 12 nearest the optical axis, the portion 230 between the gas inlet 15 and the first gas outlet 14 and the portion 240 between the second gas outlet 216 and the gas inlet 15. These portions may be moved towards and away from the substrate W by the use of piezoelectric actuators for example. That is the bottom face of the seal member 12 may comprise piezoelectric actuators (preferably stacks) which can be expanded/contracted by the application of a potential difference across them. Other mechanical means could also be used.

The pressure P3 which is created below the gas inlet 15 is determined by the pressure of gas P5 applied to the gas inlet 15, pressures of gas P6 and P4 applied to the first and second gas outlets 14 and 216 respectively and by the distance D between the substrate W and the bottom face of the seal member 12 facing the substrate W. Also the horizontal distance between the gas in and out-lets has an effect.

The weight of the seal member 12 is compensated for by the pressure of P3 so that the seal member 12 settles a distance D from the wafer W. A decrease in D leads to an increase in P3 and an increase in D will lead to a decrease in P3. Therefore this is a self regulating system.

Distance D, at a constant pushing force due to pressure P3, can only be regulated by pressures P4, P5 and P6. However, the combination of P5, P6 and D creates pressure P2 which is the pressure keeping the liquid 11 in the reservoir. The amount of liquid escaping from a liquid container at given levels of pressure can be calculated and the pressure in the liquid $P_{LIQ}$ is also important. If $P_{LIQ}$ is larger than P2, the liquid escapes from the reservoir and if $P_{LIQ}$ is less than P2, air bubbles will occur in the liquid which is undesirable. It is desirable to try to maintain P2 at a value slightly less than $P_{LIQ}$ to ensure that no bubbles form in the liquid but also to ensure that not too much liquid escapes as this liquid needs to be replaced. Preferably this can all be done with a constant D. If the distance D1 between portion 220 and the wafer W is varied, the amount of liquid escaping from the reservoir can be varied considerably as the amount of liquid escaping varies as a square of distance D1. The variation in distance required is only of the order of 1mm, preferably 10 $\mu$m and this can easily be provided by a piezoelectric stack with an operational voltage of the order of 100V or more.

Alternatively, the amount of liquid which can escape can be regulated by placing a piezoelectric element at the bottom of portion 230. Changing the distance D2 is effective to change pressure P2. However, this solution might require adjustment of pressure P5 in gas inlet 15 in order to keep D constant.

Of course the distance D3 between the lower part of portion 240 and substrate W can also be varied in a similar way and can be used to regulate independently P2 and P3. It will be appreciated that pressures P4, P5 and P6 and distances D1, D2 and D3 can all be regulated independently or in combination to achieve the desired variation of P2 and P3.

Indeed the second embodiment is particularly effective for use in active management of the quantity of liquid in the reservoir 10. The standby situation of the projection apparatus could be, where no substrate W is being imaged, that the reservoir 10 is empty of liquid but that the gas seal is active thereby to support the seal member 12. After the substrate W has been positioned, liquid is introduced into the reservoir 10. The substrate W is then imaged. Before the substrate W is removed the liquid from the reservoir can be removed. After exposure of the last substrate the liquid in the reservoir 10 will be removed. Whenever liquid is removed, a gas purge has to be applied to dry the area previously occupied by liquid. The liquid can obviously be removed easily in the apparatus according to the second embodiment by variation of P2 whilst maintaining P3 constant as described above. In other embodiments a similar effect can be achieved by varying P5 and P6 (and P4 if necessary or applicable).

Embodiment 3

As an alternative or a further development of the second embodiment as shown in Figure 6, a channel 320 may be provided in the face of the seal member 12 facing the substrate W inwardly (i.e. nearer to the optical axis of the projection system) of the first gas outlet 14. The channel 320 may have the same construction as the gas in- and out-lets 14, 15, 216.

Using the channel 320 pressure P2 may be varied independently of pressure P3. Alternatively, by opening this channel to environmental pressure above the liquid level in the reservoir 10, the consumption of liquid from the reservoir during operation is greatly reduced. This embodiment has been illustrated in combination with the second embodiment though the channel 320 may be used in combination with any of the other embodiments, in particular the first embodiment. A further advantage is that the gas inlet 15 and first gas outlet 14 (and for certain embodiments second gas outlet 216) are not disturbed.

Furthermore, although only three elements have been illustrated any number of channels may be incorporated into the face of the seal member 12 facing the substrate W, each channel being at a pressure to improve stiffness, liquid consumption, stability or other property of the liquid supply system.

Embodiment 4

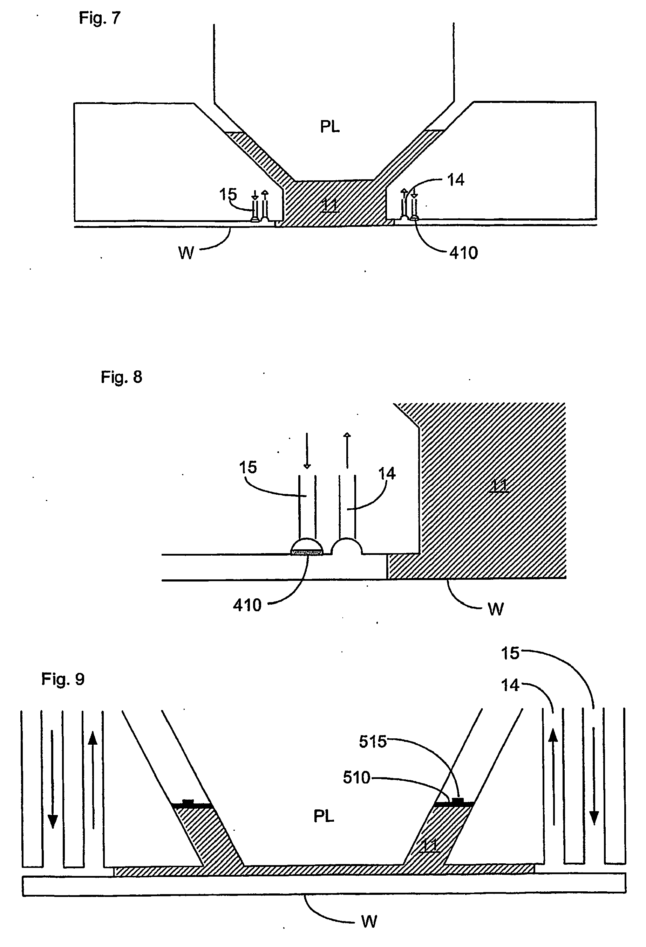

The fourth embodiment which is illustrated in Figures 7 and 8 is the same as the first embodiment except as described below. However, the fourth embodiment may also be advantageously used with any of the other embodiments described.

In the fourth embodiment a porous member 410, preferably porous carbon or a porous ceramic member, is attached to the gas inlet 15 where gas exits the bottom face of the seal member 12. Preferably the bottom of the porous member is co-planar with the bottom of the seal member. This porous carbon member 410 is insensitive to surfaces which are not completely flat (in this case substrate W) and the gas exiting the inlet 14 is well distributed over the entire exit of the inlet. The advantage gained by using the porous member 410 is also apparent when the seal member 12 is positioned partly over the edge of the substrate W as at this point the surface which the gas seal encounters is uneven.

In a variant of the fourth embodiment, the porous member 410 can be placed in the vacuum channel (s) 14. The porous member 410 should have a porosity chosen to maintain under pressure whilst preventing unacceptable pressure loss. This is advantageous when imaging the edge of the substrate W and the gas bearing moves over the edge of the substrate W be cause although the preload force at the position of the edge might be lost, the vacuum channel is not contaminated with a large and variable amount of gas, greatly reducing variations in the preload and as a consequence variation in flying height and forces on the stage.

Embodiment 5

All of the above described embodiments typically have liquid in the reservoir 10 exposed to a gas, such as air, with a free surface. This is to prevent the final element of the projection system PL from breaking in a case of a crash due to build up of hydrostatic forces on the projection system. During a crash the liquid in the reservoir 10 is unconstrained such that the liquid will easily give, i.e. be forced upwards, when the projection system PL moves against it. The disadvantage of this solution is that surface waves may occur on the free surface during operation thereby transmitting disturbance forces from the substrate W to the projection system PL, which is undesirable.

One way of solving this problem is to ensure that the reservoir 10 is completely contained within a seal member, particularly the upper surface. Liquid is then fed to the reservoir 10 through a duct from a secondary reservoir. That secondary reservoir can have an unconstrained top surface and during a crash liquid is forced through the duct into the second reservoir such that the build up of large hydrostatic forces in the first reservoir 10 on the projection system can be avoided.

In such a closed system the local build up of pressure in the liquid on the projection system is avoided by ensuring that the duct connecting the reservoirs has a cross-sectional area equivalent to a duct with a radius according to the following equation

$$R = \left( \frac{8 \Delta V \eta L}{\pi \Delta P t} \right)^{1/4}$$

where R is the duct radius, $\Delta V$ is the volume of liquid which has to be removed from the reservoir 10 within time $t$, $L$ is the length of the duct, $\eta$ is viscosity of the liquid and $\Delta P$ is the pressure difference between the secondary reservoir and the primary reservoir 10. If an assumption is made that the substrate table can crash with a speed of 0.2 m/sec (measured by experiment) and $\Delta P_{max}$ is $10^4$ Pa (about the maximum pressure the final element of the project system can withstand before damage results), the required pipe radius is about 2.5 millimeters for a duct length of 0.2 m. Preferably the effective radius of the duct is at least twice the minimum given by the formula.

An alternative way to avoid the buildup of waves in the liquid in the reservoir whilst still ensuring that the projection system PL is protected in a crash, is to provide the free surface of the liquid with a suppression membrane 510 on the top surface of the liquid in the reservoir 10. This solution requires a safety means 515 to allow the liquid to escape in the case of a crash without the build-up of too high a pressure. One solution is illustrated in Figure 9. The suppression membrane may be made of a flexible material which is attached to the wall of the seal member 12 or the projection system in such a way that before the pressure in the liquid reaches a predetermined allowed maximum, liquid is allowed to deform the flexible suppression membrane 510 such that liquid can escape between the projection system PL and the suppression membrane 510 or between the suppression membrane and the seal member, respectively. Thus in a crash it is possible for liquid to escape above the safety membrane without damaging with projection system PL. For this embodiment it is obviously preferable to have a space above the suppression membrane of at least the volume of a reservoir 10. Thus the flexible membrane is stiff enough to prevent the formation of waves in the top surface of the liquid in the reservoir 10 but is not stiff enough to prevent liquid escaping once the liquid reaches a predetermined hydrostatic pressure. The same effect can be achieved by use of pressure valves 515 which allow the free-flow of liquid above a predetermined pressure in combination with a stiffer suppression membrane.

An alternative form of suppression means is to place a high viscosity liquid on the top free surface of the liquid in the reservoir 10. This would suppress surface wave formation whilst allowing liquid to escape out of the way of the projection system PL in the case of a crash. Obviously the high viscosity liquid must be immiscible with the liquid used in the space 10.

A further alternative for the liquid suppression means 510 is for it to comprise a mesh. In this way the top surface of the liquid can be split into several parts each of smaller area. In this way, development of large surface waves which build up due to resonance and disturb the projection system is avoided because the surface area of the several parts is equal to the mesh opening so that the generation of large surface waves is effectively damped. Also, as the mesh allows flow of liquid through its openings, an effective pressure release mechanism is provided for the protection of the projection system in the case of a crash.

Embodiment 6

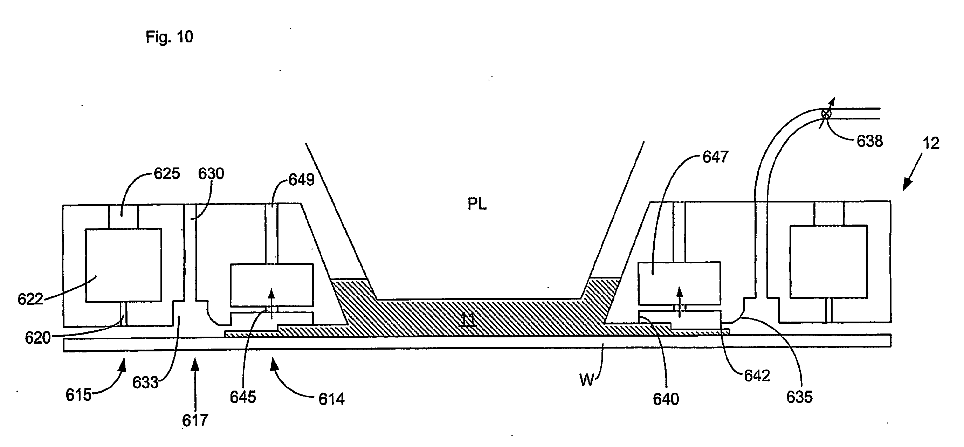

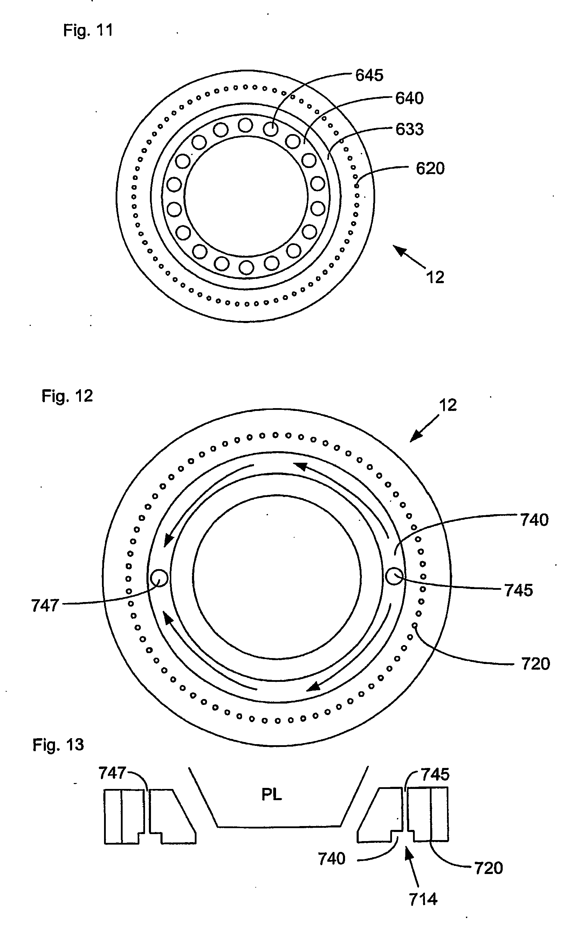

The sixth embodiment as illustrated in Figures 10 and 11 is the same as the first embodiment except as described below. The sixth embodiment uses several of the ideas in the foregoing embodiments.

As with the other embodiments, the immersion liquid 11 is confined to an area under the projection system PL by a seal member 12 positioned below and surrounding the final element of a projection system.

The gas seal between the seal member 12 and the substrate W is formed by three types of in-and-outlet. The seal member is generally made up of an outlet 614, an inlet 615 and a further inlet 617. These are positioned with the outlet 614 nearest the projection system PL, readily outwardly of the outlet 614 the further inlet 617 and furthest from the projection system PL the inlet 615. The inlet 615 comprises the air bearing in which gas is provided to a plurality of outlet holes 620 in the surface of the seal member 12 facing the substrate W via an annular chamber 622. The force of the air exiting the outlet 620 both supports at least part of the weight of the seal member 12 and well as providing a flow of air towards the outlet 614 which helps seal the immersion liquid to be confined to a local area under the projection system PL. The purpose of the chamber 622 is so that the discrete gas supply orifice(s) 625 provide gas at a uniform pressure at the outlet holes 620. The outlet holes 620 are about 0.25 mm in diameter and there are approximately 54 outlet holes 620. There is an order of magnitude difference in flow restriction between the outlet holes 620 and the chamber 622 which ensures an even flow out of all of the outlet holes 620 despite the provision of only a small number or even only one main supply orifice 625.

The gas exiting the outlet holes 620 flows both radially inwardly and outwardly. The air flowing radially inwardly up the outlet 614 is effective to form a seal between the seal member 12 and the substrate W. However, it has been found that the seal is improved if a further flow of air is provided by a further inlet 617. Passage 630 is connected to a gas source, for example the atmosphere. The flow of air radially inwardly from the inlet 615 is effective to draw further gas from the further inlet 617 towards the outlet 614.

An annular groove 633 which is provided at the end of the passage 630 (rather than a series of discrete inlets) ensures that the sealing flow of gas between the inner most edge of the groove 633 and the outlet 614 is even around the whole circumference. The groove is typically 2.5 mm wide and of a similar height.

The inner most edge 635 of the groove 633 is, as illustrated, provided with a radius to ensure smooth flow of the gas through passage 630 towards the outlet 614.

The outlet 614 also has a continuous groove 640 which is approximately only 0.7 mm high but 6 to 7 mm wide. The outer most edge 642 of the groove 640 is provided as a sharp, substantially 90°, edge so that the flow of gas, in particular the flow of gas out of further inlet 630 is accelerated to enhance the effectiveness of the gas seal. The groove 640 has a plurality of outlet holes 645 which lead into an annular chamber 647 and thus to discrete outlet passage 649. The plurality of outlet holes 645 are approximately 1mm in diameter such that water droplets passing through the outlet holes 645 are broken up into smaller droplets.

The effectiveness of liquid removal of the seal member 12 can be adjusted by an adjustable valve 638 connected to the further inlet 617. The valve 638 is effective to adjust the flow through further inlet 617 thereby to vary the effectiveness of liquid removal of the gas seal 12 through outlet 614.

The overall diameter of the seal member is of the order of 100 mm.

Figure 11 shows, in plan, the underside of the seal member 12 of Figure 10. As can be seen, the inlet 615 is provided as a plurality of discrete inlet holes 620. This is advantageous over the use of a groove for the main inlet 615 because a groove as an air bearing has a capacity (because of the compressable nature of gas) such that vibrations can be set up in such a system. Small diameter inlet holes 620 have a lower volume of gas in them and therefore suffer less from problems arising from capacity.

The use of a further inlet 617 in the form of a groove 633 can be used to ensure a continuous gas flow around the whole circumference of the seal member 12 which would not necessarily be possible when only using discrete inlet holes 620. The provision of the outlets 645 as discrete entities is not a problem because of the provision of the groove 640 which is effective, like chambers 647 and 622, to even out the flow.

The inlets for liquid are not illustrated in the seal member 12 of Figures 10 and 11. The liquid may be provided in the same manner as illustrated in the foregoing embodiments or, alternatively, any of the liquid inlets and outlets as described in European Patent Application Nos. 03256820.6 and 03256809.9.

Embodiment 7

The seventh embodiment is similar to the sixth embodiment except as described below. Figure 12 is a plan view of the underside of the seal member 12 similar to that shown in Figure 11. In Figure 12 the seal member is not provided with a further inlet as in the sixth embodiment though this can optionally be added.

The seal member 12 of the seventh embodiment comprises a gas bearing formed by inlet holes 720 and which is of the same overall design as the sixth embodiment. The inlet 714 comprises a annular groove 740 with only two passages 745, 747 which lead to a gas source and a vacuum source respectively. In this way a high speed flow of gas from the gas source connected to passage 745 towards the vacuum source connected to passage 747 can be established. With this high speed flow of gas, immersion liquid can be drained more effectively. Furthermore, by creating a larger restricted vacuum flow in the vacuum chamber, flow fluctuations due to variations in the height of the seal member 12 above the substrate W or other leakage sources in the surface will not influence the vacuum chamber pressure providing the preload for the gas bearing.

Embodiment 8

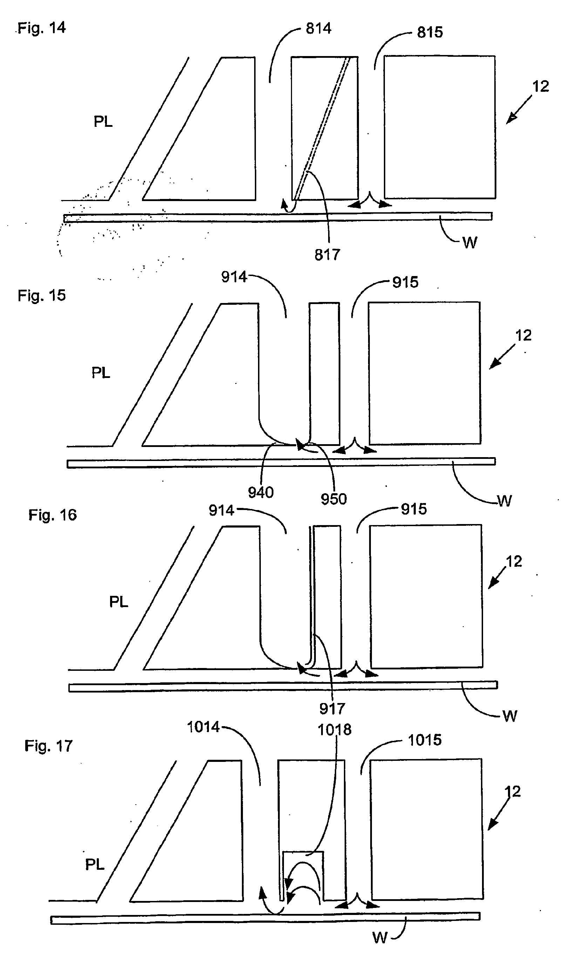

The eighth embodiment will be described in relation to Figure 14 and is the same as the first embodiment except as described below.

As can be seen from Figure 14, the eighth embodiment has a seal member 12 with an inlet 815 and an outlet 814 just like the first embodiment. However, a further inlet 817 is provided which is arranged so that a jet of gas can be formed which increases the velocity of the gas on the surface of the substrate W below or marginally radially outwardly of the outlet 14 so that immersion liquid is more effectively removed from the surface of the substrate W. The further inlet 817 has an exit provided by a nozzle which is directed towards the substrate W at an angle radially inwardly towards the projection system PL. Thus, the otherwise laminar air flow (with a Reynolds number of around 300) between the inlet 815 and the outlet 814 and which has a simple parabolic speed distribution with a zero speed on the surface of the substrate, which cannot remove the last few micro meters of liquid film from the wafer, is improved because the further inlet 817 ensures that gas with a higher air velocity is in contact with the substrate surface.

From Figure 14 it can be seen that the exit nozzle of the further inlet 817 is provided radially outwardly of the outlet 814 but closer to the outlet 814 than to the inlet 815.

Embodiment 9

The ninth embodiment is illustrated in Figures 15 and 16 and is the same as the first embodiment except as described below.

In the ninth embodiment the mouth of the outlet 914 in the bottom surface of the seal member 12 which faces the substrate W, is modified to increase the velocity of air into the outlet 914. This is achieved by reducing the size of the mouth of the inlet 914 whilst keeping the passageway of the outlet 914 the same size. This is achieved by providing a smaller mouth by extending material of the seal member 12 towards the center of the passage to form an outer addition member 940 and an inner additional member 950. The outer additional member 940 is smaller than the inner additional member 950 and the gap between those two members 940, 950 is approximately 20 times smaller than the remainder of the outlet 914. The mouth is approximately 100 to 300 $\mu$m in width.

In Figure 16 a further alternative version of the ninth embodiment is depicted in which a further inlet 917 similar to the further inlet 817 of the eight embodiment is provided. However, in this case the further inlet 917 provides a jet of flow substantially parallel to the surface of the substrate W so that the gas entering the mouth of the outlet 914 is accelerated.

Embodiment 10

The tenth embodiment is illustrated in Figure 17 and is the same as the first embodiment except as described below.

In the tenth embodiment the efficiency of liquid removal is improved by increasing the velocity of gas on the surface of the substrate W along the same principles as in the eight embodiment. Gas leaving inlets 1015 and moving radially inwardly towards an outlet 1014 passes underneath an annular groove 1018. The effect of the groove, as illustrated, is for the gas to enter the groove on its radially outer most side and to exit it, with an angle towards the substrate W, on the radially inward side. Thus, the speed of the gas on the surface of the substrate W at the entrance to the outlet 1014 is increased and liquid removal efficiency is improved.

It will be clear that features of any embodiment can be used in conjunction with some or all features of any other embodiment.

Whilst specific embodiments of the invention have been described above, it will be appreciated that the invention may be practiced otherwise than as described. The description is not intended to limit the invention.

**Claims**

1. A lithographic projection apparatus comprising:

    - a radiation system for supplying a projection beam of radiation;
    - a support structure (MT) for supporting patterning means (MA), the patterning means (MA) serving

    to pattern the projection beam according to a desired pattern;

    - a substrate table (WT) for holding a substrate (W);
    - a projection system (PL) for projecting the patterned beam onto a target portion of the Substrate (W); and
    - a liquid supply system for at least partly filling a space (11) between the final element of said projection system and said substrate with a liquid;

    said space is in liquid connection with a liquid reservoir through a duct, **characterized in that** the cross sectional area of said duct in a plane perpendicular to the direction of fluid flow is at least

    $$\pi \left( \frac{8 \Delta V \eta L}{\pi \Delta P_{max} t_{min}} \right)^{1/2}$$ where $\Delta V$ is the volume of liquid which has to be removed from said space (11) within time $t_{min}$, $L$ is the length of the duct, $\eta$ is viscosity of liquid in said space (11) and $\Delta P_{max}$ is the maximum allowable pressure on said final element.

2. The apparatus of claim 1, wherein said space is enclosed such that when liquid is present in said space (11), said liquid has no free upper surface.

**3.** Apparatus according to any of the preceding claims, wherein said liquid supply system comprises:

a seal member (12) extending along at least a part of the boundary of said space (11) between the final element of said projection system (PL) and said substrate table (WT); and
a gas seal means for forming a gas seal between said seal member (12) and the surface of said substrate (W) and wherein said gas seal means comprises a gas inlet (15) and a first gas outlet (14)
formed in a face of said seal member (12) that opposes said substrate (W), means for supplying gas
under pressure to said gas inlet (15) and vacuum means for extracting gas from said first gas outlet (14).

**4.** Apparatus according to claim 3, wherein said gas seal means is a gas bearing for supporting said seal member (12) over said substrate (W).

**5.** Apparatus according to claim 3 or 4, further comprising a further inlet connected to a gas source and positioned between said first gas outlet (14) and said gas inlet (15).

**6.** Apparatus according to claim 5, wherein said further inlet comprises a continuous annular groove in a surface of said seal member (12) facing said substrate (W).

**7.** Apparatus according to claim 6, wherein a radially innermost corner of said groove has a radius.

**8.** Apparatus according to any one of claims 3 to 7, wherein said gas inlet (15) is located further outward from the optical axis of said projection system than is said first gas outlet (14).

**9.** Apparatus according to any one of claims 3 to 8, further comprising sensors for measuring the distance between said face of said seal member (12) and said substrate (W) and/or the topography of said substrate (W).

**Patentansprüche**

**1.** Ein lithographisches Projektionsgerät, das Folgendes beinhaltet:

- ein Strahlungssystem zum Zuführen eines Projektionsstrahls aus Strahlung;
- eine Stützstruktur (MT) zum Stützen eines Musteraufbringungsmittels (MA), wobei das Musteraufbringungsmittel (MA) dazu dient, den Projektionsstrahl gemäß einem gewünschten Muster zu mustern;
- einen Substrattisch (WT) zum Halten eines Substrats (W);
- ein Projektionssystem (PL) zum Projizieren des gemusterten Strahls auf einen Zielabschnitt des Substrats (W); und
- ein Flüssigkeitszufuhrsystem, um einen Raum (11) zwischen der Endkomponente des Projektionssystems und dem Substrat mindestens teilweise mit einer Flüssigkeit zu füllen;

wobei der Raum durch einen Durchgang mit einem Flüssigkeitsbehälter in flüssiger Verbindung steht, **dadurch gekennzeichnet, dass** der Querschnittsbereich des Durchgangs in einer Ebene, die zu der Richtung der Fluidströmung senkrecht steht, mindestens $\pi \left( \frac{8\Delta V \eta L}{\pi \Delta P_{\max} t_{\min}} \right)^{1/2}$ beträgt, wobei $\Delta V$ das Volumen der Flüssigkeit ist, das innerhalb der Zeit $t_{min}$ aus dem Raum (11) entfernt werden muss, $L$ die Länge des Durchgangs ist, $\eta$ die Viskosität der Flüssigkeit in dem Raum (11) ist und $\Delta P_{max}$ der maximal zulässige Druck auf die Endkomponente ist.

**2.** Gerät gemäß Anspruch 1, wobei der Raum umschlossen ist, so dass, wenn in dem Raum (11) Flüssigkeit vorhanden ist, die Flüssigkeit keine freie obere Oberfläche aufweist.

**3.** Gerät gemäß einem der vorhergehenden Ansprüche, wobei das Flüssigkeitszufuhrsystem Folgendes beinhaltet:

ein Dichtungselement (12), das sich entlang mindestens einem Teil der Grenze des Raums (11) zwischen der Endkomponente des Projektionssystems (PL) und dem Substrattisch (WT) erstreckt; und
ein Gasdichtungsmittel zum Bilden einer Gasdichtung zwischen dem Dichtungselement (12) und der Oberfläche des Substrats (W), und wobei das Gasdichtungsmittel einen Gaseinlass (15) und einen ersten Gasauslass (14), die in einer Fläche des Dichtungselements (12), welche dem Substrat (W) gegenüberliegt, gebildet sind, ein Mittel zum Zuführen von Gas unter Druck zu dem Gaseinlass (15) und ein Vakuummittel zum Extrahieren von Gas aus dem ersten Gasauslass (14) beinhaltet.

**4.** Gerät gemäß Anspruch 3, wobei das Gasdichtungsmittel ein Gaslager zum Stützen des Dichtungselements (12) über dem Substrat (W) ist.

**5.** Gerät gemäß Anspruch 3 oder 4, das ferner einen weiteren Einlass beinhaltet, der mit einer Gasquelle verbunden und zwischen dem ersten Gasauslass (14) und dem Gaseinlass (15) positioniert ist.

6. Gerät gemäß Anspruch 5, wobei der weitere Einlass in einer Oberfläche des Dichtungselements (12), die dem Substrat (W) zugewandt ist, eine durchgehende ringförmige Rille beinhaltet.

7. Gerät gemäß Anspruch 6, wobei eine radial innerste Ecke der Rille einen Radius aufweist.

8. Gerät gemäß einem der Ansprüche 3 bis 7, wobei sich der Gaseinlass (15) von der optischen Achse des Projektionssystems weiter auswärts befindet als der erste Gasauslass (14).

9. Gerät gemäß einem der Ansprüche 3 bis 8, das ferner Sensoren zum Messen der Entfernung zwischen der Fläche des Dichtungselements (12) und dem Substrat (W) und/oder der Topographie des Substrats (W) beinhaltet.

## Revendications

1. Un appareil de projection lithographique, comprenant :

    - un système de rayonnement destiné à fournir un faisceau de projection de rayonnement ;
    - une structure formant support (MT) destinée à supporter un moyen pour conformer selon un motif (MA), le moyen pour conformer selon un motif (MA) servant à conformer le faisceau de projection selon un motif souhaité ;
    - une table porte-substrat (WT) destinée à porter un substrat (W) ;
    - un système de projection (PL) destiné à projeter le faisceau à motif sur une portion cible du substrat (W) ; et
    - un système d'alimentation en liquide destiné à remplir au moins partiellement un espace (11) entre l'organe final dudit système de projection et ledit substrat avec un liquide ;

    ledit espace étant en raccordement liquidique avec un réservoir de liquide par l'intermédiaire d'une canalisation, **caractérisé en ce que** la superficie en coupe transversale de ladite canalisation dans un plan perpendiculaire à la direction d'écoulement de fluide est au moins

    $\pi \left( \frac{8\Delta V \eta L}{\pi \Delta P_{\max} t_{\min}} \right)^{1/2}$ où $\Delta V$ est le volume de liquide qui doit être retiré dudit espace (11) dans le temps $t_{min}$, $L$ est la longueur de la canalisation, $\eta$ est la viscosité du liquide dans ledit espace (11) et $\Delta P_{max}$ est la pres-

sion maximale admissible sur ledit organe final.

2. L'appareil de la revendication 1, dans lequel ledit espace est encloisonné de telle sorte que, lorsqu'il est présent du liquide dans ledit espace (11), ledit liquide n'ait pas de surface supérieure libre.

3. Appareil selon n'importe lesquelles des revendications précédentes, dans lequel ledit système d'alimentation en liquide comprend :

    un élément d'étanchéité (12) s'étendant le long d'au moins une partie du pourtour dudit espace (11) entre l'organe final dudit système de projection (PL) et ladite table porte-substrat (WT) ; et
    un moyen d'étanchéité à gaz destiné à former un joint de gaz entre ledit élément d'étanchéité (12) et la surface dudit substrat (W) et dans lequel ledit moyen d'étanchéité à gaz comprend un orifice d'entrée de gaz (15) et un premier orifice de sortie de gaz (14) formés dans une face dudit élément d'étanchéité (12) qui est face audit substrat (W), un moyen pour fournir du gaz sous pression audit orifice d'entrée de gaz (15) et un moyen à vide pour extraire du gaz dudit premier orifice de sortie de gaz (14).

4. Appareil selon la revendication 3, dans lequel ledit moyen d'étanchéité à gaz est un palier à gaz destiné à supporter ledit élément d'étanchéité (12) par-dessus ledit substrat (W).

5. Appareil selon la revendication 3 ou la revendication 4, comprenant en outre un orifice d'entrée supplémentaire raccordé à une source de gaz et positionné entre ledit premier orifice de sortie de gaz (14) et ledit orifice d'entrée de gaz (15).

6. Appareil selon la revendication 5, dans lequel ledit orifice d'entrée supplémentaire comprend une rainure annulaire continue dans une surface dudit élément d'étanchéité (12) qui fait face audit substrat (W).

7. Appareil selon la revendication 6, dans lequel un coin le plus radialement interne de ladite rainure a un rayon.

8. Appareil selon l'une quelconque des revendications 3 à 7, dans lequel ledit orifice d'entrée de gaz (15) est situé plus vers l'extérieur par rapport à l'axe optique dudit système de projection que ne l'est ledit premier orifice de sortie de gaz (14).

9. Appareil selon l'une quelconque des revendications 3 à 8, comprenant en outre des capteurs destinés à mesurer la distance entre ladite face dudit élément d'étanchéité (12) et ledit substrat (W) et/ou la topographie dudit substrat (W).

Fig. 1

## Fig. 2

## Fig. 3

## Fig. 4

Fig. 5

240

230

P4   P5   P6

15

14

216

220

11

D P1   D3   P3   D2   D1   P2

W

Fig. 6

P4   P5   P6

216   15   14

320

P2

216

P3

P2

W

Fig. 7

Fig. 8

Fig. 9

Fig. 10

Fig. 11

Fig. 12

Fig. 13

PL

Fig. 14

Fig. 15

Fig. 16

Fig. 17

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5296891 A
- US 5523193 A
- WO 9838597 A
- WO 9833096 A
- US 5229872 A
- US 6046792 A

- US 5969441 A
- WO 9840791 A
- WO 9949504 A
- DD 224448 A1
- EP 03256820 A
- EP 03256809 A

**Non-patent literature cited in the description**

- **PETER VAN ZANT.** Microchip Fabrication: A Practical Guide to Semiconductor Processing. McGraw Hill Publishing Co, 1997